# EUROPÄISCHE PATENTSCHRIFT

(11) **EP 1 110 250 B1**
(45) Veröffentlichungstag und Bekanntmachung des Hinweises auf die Patenterteilung: **08.09.2004**
(21) Anmeldenummer: 00949090.5
(22) Anmeldetag: 19.06.2000
(51) Int. Cl.: H01L 41/047, H01L 41/083

(54) **PIEZOAKTOR MIT WÄRMEDEHNUNGSANGEPASSTER AUSSENELEKTRODE**
PIEZOELECTRIC ACTUATOR WITH AN OUTER ELECTRODE THAT IS ADAPTED FOR THERMAL EXPANSION
ACTIONNEUR PIEZO-ELECTRIQUE DOTE D'UNE ELECTRODE EXTERIEURE ADAPTEE A LA DILATATION THERMIQUE

(30) Priorität: 19.06.1999 DE 19928190
(43) Veröffentlichungstag der Anmeldung: 27.06.2001
(73) Patentinhaber: ROBERT BOSCH GMBH, 70442 Stuttgart (DE)
(72) Erfinder: HEINZ, Rudolf, D-71272 Renningen (DE); HEDRICH, Alexander, D-70499 Stuttgart (DE)
(86) Internationale Anmeldenummer: PCT/DE2000/001930
(87) Internationale Veröffentlichungsnummer: WO 2000/079608

(56) Entgegenhaltungen:
- EP-A- 0 844 678
- DE-A- 19 753 930
- PATENT ABSTRACTS OF JAPAN vol. 1995, no. 11, 26. Dezember 1995 (1995-12-26) & JP 07 226544 A (NIPPONDENSO CO LTD), 22. August 1995 (1995-08-22)

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Der Aufbau dieses Piezoaktors kann hier in mehreren Schichten erfolgen (Multilayer-Aktoren), wobei die Elektroden, über die die elektrische Spannung aufgebracht wird, jeweils zwischen den Schichten angeordnet werden.

Solche Piezoaktoren könne beispielsweise für den Antrieb von Schaltventilen bei Kraftstoffeinspritzsystemen in Kraftfahrzeugen vorgesehen werden. Beim Betrieb des Piezoaktors ist hier insbesondere darauf zu achten, dass durch mechanische Spannungen im Lagenaufbau auch keine störenden Rissbildungen im Bereich der äußeren Anschlusselektroden entstehen. Da die jeweils an einer Seite kontaktierten Innenelektroden kammartig in den Lagenaufbau integriert sind, müssen die in Richtung des Lagenaufbaus aufeinanderfolgenden Elektroden jeweils abwechselnd an gegenüberliegenden Seiten kontaktiert werden. Bei einer Betätigung des Piezoaktors, d.h. bei Anlage einer Spannung zwischen den im Lagenaufbau gegenüberliegenden Innenelektroden treten unterschiedliche mechanische Kräfte im Bereich der Innenelektroden sowie im Bereich der Kontaktierungen an den Außenelektroden auf, die zu mechanischen Spannungen und dadurch zu Rissen in den Außenelektroden führen können.

### Vorteile der Erfindung

Der eingangs beschriebene Piezoaktor, der beispielsweise zur Betätigung eines mechanischen Bauteils verwendbar sein kann, ist in vorteilhafter Weise dadurch weitergebildet, dass bei einem Mehrschichtaufbau von keramischen Piezolagen und dazwischen angeordneten Innenelektroden, als eine erste Außenelektrode eine leitende Fläche auf jeweils einer Seitenfläche angebracht ist, die mit den jeweiligen Innenelektroden kontaktiert ist und eine zweite netz-, gewebeartige oder gewellte Außenelektrode auf der ersten angeordnet ist. Die zweite Außenelektrode ist zumindest punktweise mit der ersten kontaktiert, wobei zwischen den Kontaktierungen dehnbare Bereiche zu liegen kommen. Eine solche Anordnung ist beispielsweise aus EP 0 844 678 bekannt.

In den Bereichen zwischen zwei Piezolagen, die jeweils eine an der jeweils gegenüberliegenden Seite kontaktierte Innenelektrode aufweisen, ist eine passive Zone ohne Innenelektrodenschicht vorhanden, wobei erfindungsgemäß das keramische Piezomaterial zumindest in der passiven Zone und das Material der zweiten Außenelektrode einen nahezu gleichen Temperaturausdehnungskoeffizienten aufweisen.

Die erste Außenelektrode kann eine dünne, z.B. einige µm dicke Schicht aus Ni, Ni+Cu oder Ni+PbSn sein, die direkt auf der Oberfläche des Piezoaktors haftet; die zweite Außenelektrode ist hier zum Schutz gegen Querrisse angeordnet, die die Stromleitung in der Außenelektrode unterbrechen kann. Die Querrisse können an der ersten Außenelektrode durch Delamination in den Innenelektroden, infolge von Zugspannungen in den Piezolagen in den passiven Zonen, entstehen. Durch die Anordnung der netzartigen zweiten Außenelektrode werden die Querrisse gestoppt und die ev. in der ersten Außenelektrode unterbrochene Stromleitung überbrückt.

Außerdem kommt es bei schnellen TemperaturwechseIn von beispielsweise -40°C bis +160°C im Piezoaktor auch ev. zu Ablösungen zwischen der ersten Außenelektrode und der Piezokeramik infolge zu großer Schubspannungen, wenn die Temperaturausdehnungskoeffizienten des Piezokeramikmaterials und des Materials der Außenelektroden zu sehr voneinander abweichen. Insbesondere die zweite Außenelektrode würde dann wegen der größeren Dicke (ca. 100 µm) im Vergleich zur ersten Schicht (ca. 5 µm) große Schubkräfte erzeugen.

In besonders vorteilhafter Weise können die mechanischen Spannungen im Piezoaktor vermindert werden, wenn die keramischen Piezolagen und die zweiten Außenelektroden einen annähernd übereinstimmenden Temperaturausdehnungskoeffizienten von ca. 1 ∗ 10⁻⁶ ∗ 1/K bis 10 ∗ 10⁻⁶ ∗ 1/K aufweisen. Als Herstellungsmaterial kommt dabei für die keramischen Piezolagen Bleizirkonattitanat und für die zweiten Außenelektroden Eisen-Nickel-Legierungen, z.B. Invar, in Frage. Zur Verbesserung der Lötbarkeit dieses Materials kann es zunächst mit einer dünnen (z.B. 5 bis 10 µm) Schicht aus Kupfer beschichtet werden. Danach kann eine Sn-Pb-Lotschicht aufgebracht werden, um die zweite Außenelektrode auf die erste aufzulöten.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier nach den Ansprüchen 1-4 Schutz beansprucht wird.

### Zeichnung

Ein Ausführungsbeispiel des erfindungsgemäßen Piezoaktors wird anhand der Zeichnung erläutert. Es zeigen:
Figur 1 einen Schnitt durch einen Piezoaktor mit einem Mehrschichtaufbau von Lagen aus Pizokeramik und
Innenelektroden sowie einer netzartigen Außenelektrode auf einer ersten flächigen Außenelektrode;
Figur 2 eine Draufsicht auf die netzartige Außenelektrode nach der Figur 1 und
Figur 3 einen Detailschnitt durch den Lagenaufbau und die Außenelektroden in passiven Zonen der Piezolagen mit den dort durch auftretende mechanische Schub- und Querspannungen entstehenden Rissen.

### Beschreibung des Ausführungsbeispiels

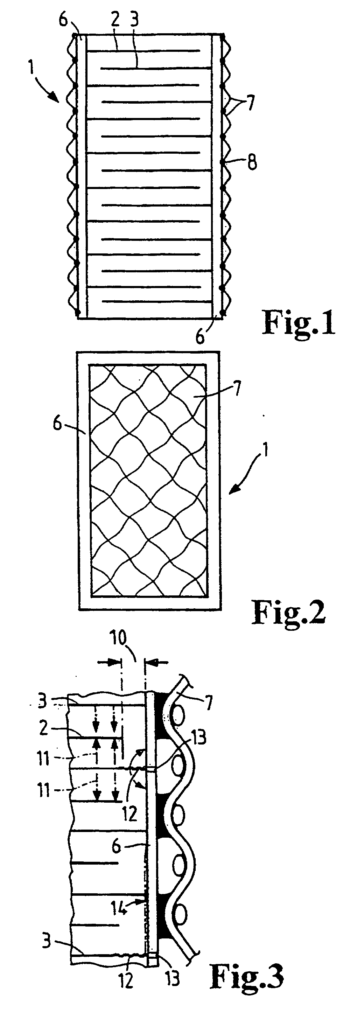

In Figur 1 ist ein Piezoaktor 1 gezeigt, der in an sich bekannter Weise aus Piezofolien eines Keramikmaterials mit einer geeigneten Kristallstruktur aufgebaut ist, so dass unter Ausnutzung des sogenannten Piezoeffekts bei Anlage einer äußeren elektrischen Spannung an Innenelektroden 2 und 3 eine mechanische Reaktion des Piezoaktors 1 erfolgt. Aus Figur 2 ist eine Seitenansicht dieser Anordnung zu entnehmen.

Mit den Innenelektroden 2 und 3 steht eine erste flächige Außenelektrode 6 in Kontakt, die wiederum mit einer zweiten netzartigen Außenelektrode 7 über Punktkontakte 8, beispielsweise durch Löten oder Schweißen, kontaktiert ist. Die erste Außenelektrode 6 kann eine dünne, z.B. einige µm dicke, Schicht aus Ni, Ni+Cu oder Ni+PbSn sein, die direkt auf der Oberfläche des Piezoaktors 1 haftet.

Beim Detailschnitt nach Figur 3 ist der Lagenaufbau und sind die seitlich anliegenden Außenelektroden 6 und 7 nach den Figuren 1 und 2 deutlich zu erkennen. Es ist hier eine passive Zone 10 angedeutet, in der das elektrische Feld gemäß der Pfeile 11 nicht stark ausgeprägt ist, wodurch die Dehnung des Piezoaktors 1 nicht frei erfolgt sondern über Zugspannung im Keramikmaterial des Piezoaktors 1 erzwungen wird. Dadurch können Delaminationen 12 entstehen, die hier an einigen Innenelektroden 3 angedeutet sind. Die Delamination 12 kann dabei in einen Riss 13 in der ersten Außenelektrode 6 übergehen. Allerdings wird der Riss 13 durch die netzartige zweite Außenelektrode 7 gestoppt und leitend überbrückt.

Weiterhin sind in der Figur 3 auch Schubrisse 14 angedeutet, die zwischen dem Keramikmaterial der Piezolagen und der ersten Außenelektrode 6 durch unterschiedliche Temperaturausdehnung der Piezokeramik und der zweiten Außenelektrode 7 entstehen können. Die relativ dünne erste Außenelektrode 6 hat hier keinen großen Einfluss.

## Patentansprüche

1. Piezoaktor, mit
- einem Mehrschichtaufbau von keramischen Piezolagen und dazwischen angeordneten Innenelektroden (2,3),
- einer wechselseitigen seitlichen Kontaktierung der Innenelektroden (2,3) über Außenelektroden (6,7), über die eine elektrische Spannung zuführbar ist, wobei
- als eine erste Außenelektrode (6) eine leitende Fläche auf jeweils einer Seitenfläche angebracht ist, die mit den jeweiligen Innenelektroden (2,3) kontaktiert ist und eine zweite netz-, gewebeartige oder gewellte Außenelektrode (7) auf der ersten (6) angeordnet ist, wobei die zweite Außenelektrode zumindest punktweise mit der ersten (6) kontaktiert ist und wobei zwischen den Kontaktierungen dehnbare Bereiche liegen und wobei
- in den Bereichen zwischen zwei Piezolagen, die jeweils eine an der jeweils gegenüberliegenden Seite kontaktierte Innenelektrode (2,3) aufweisen eine passive Zone (10) ohne Innenelektrodenschicht vorhanden ist, **dadurch gekennzeichnet, dass** das keramische Piezomaterial zumindest in der passiven Zone (10) und das Material der zweiten Außenelektroden (7) einen nahezu gleichen Temperaturausdehnungskoeffizienten aufweisen.

2. Piezoaktor nach Anspruch 1, **dadurch gekennzeichnet, dass**
- die keramischen Piezolagen und die zweite Außenelektrode (7) einen Temperaturausdehnungskoeffizienten von ca. 1 ∗ 10⁻⁶ ∗ 1/K bis 10 ∗ 10⁻⁶ ∗ 1/K aufweisen.

3. Piezoaktor nach Anspruch 2, **dadurch gekennzeichnet, dass**
- die keramischen Piezolagen aus Bleizirkonattitanat sind.

4. Piezoaktor nach Anspruch 2 oder 3, **dadurch gekennzeichnet, dass**
- die zweite Außenelektrode (7) aus einer Eisen-Nickel-Legierung, gegebenenfalls mit einer Kupferbeschichtung, hergestellt sind.

## Claims

1. Piezoelectric actuator, having
- a multi-layer structure composed of ceramic. piezoelectric layers and inner electrodes (2, 3) arranged between them,
- alternating lateral contacting of the inner electrodes (2, 3) via outer electrodes (6, 7), by means of which an electric voltage can be supplied, wherein
- a conductive area is arranged in each case on a side face, as a first outer electrode (6), contact being made between this conductive area and the respective inner electrodes (2, 3), and a second mesh-like, fabric-like or corrugated outer electrode (7) being arranged on the first outer electrode (6), at least punctiform contact being made between the second outer electrode and the first outer electrode (6), and expandable areas being present between the contact-making locations, and wherein
- a passive zone (10) without an inner electrode layer is present in the regions between two piezoelectric layers, which each have an inner electrode (2, 3) with which contact is made on the respectively opposite side, **characterized in that** the ceramic piezoelectric material, at least in the passive zone (10), and the material of the second outer electrode (7) have virtually identical coefficients of thermal expansion.

2. Piezoelectric actuator according to Claim 1, **characterized in that**
- the ceramic piezoelectric layers and the second outer electrode (7) have a coefficient of thermal expansion of approx. 1 ∗ 10⁻⁶ ∗ 1/K to 10 ∗ 10⁻⁶ ∗ 1/K.

3. Piezoelectric actuator according to Claim 2, **characterized in that**
- the ceramic piezoelectric layers are formed from lead zirconate titanate.

4. Piezoelectric actuator according to Claim 2 or 3, **characterized in that**
- the second outer electrode (7) is made from an iron-nickel alloy, if appropriate with a copper coating.

## Revendications

1. Actionneur piézo-électrique comprenant :
- une configuration multicouches de couches piézo-céramiques et des électrodes intérieures (2, 3) disposées entre celles-ci,
- une liaison latérale mixte des électrodes intérieures (2, 3) sur des électrodes extérieures (6, 7), permettant d'alimenter une tension électrique,
dans lequel :
- sous la forme d'une première électrode extérieure (6), une surface conductrice sur laquelle une surface latérale est respectivement disposée est en contact avec les électrodes intérieures respectives (2, 3), et une seconde électrode extérieure (7) réticulée, tissée ou ondulée, est disposée sur la première électrode (6), la seconde électrode extérieure étant en contact avec la première (6) au moins en certains points, et des régions pouvant se dilater se situant entre les liaisons, et
- dans les régions entre deux couches piézo-électriques qui présentent respectivement une électrode intérieure (2, 3) en contact avec la face respectivement opposée, se trouve une zone passive (10) sans couche d'électrodes intérieures,
**caractérisé en ce que**
le matériau piézo-céramique au moins dans la zone passive (10) et le matériau des secondes électrodes extérieures (7) présentent un coefficient de dilatation thermique presque identique.

2. Actionneur piézo-électrique selon la revendication 1,
**caractérisé en ce que**
les couches piézo-céramiques et la seconde électrode extérieure (7) présentent un coefficient de dilatation thermique d'environ 1 ∗ 10⁻⁶ ∗ 1/K à 10 ∗ 10⁻⁶ ∗ 1/K.

3. Actionneur piézo-électrique selon la revendication 2,
**caractérisé en ce que**
les couches piézo-céramiques sont composées de titanate zirconate de plomb.

4. Actionneur piézo-électrique selon la revendication 2 ou 3,
**caractérisé en ce que**,
la seconde électrode extérieure (7) est composée d'un alliage fer-nickel, le cas échéant dotée d'un revêtement en cuivre.
